Europäisches Patentamt

European Patent Office

Office européen des brevets

(19)

(11) **EP 0 877 231 B1**

(12) **FASCICULE DE BREVET EUROPEEN**

(45) Date de publication et mention
de la délivrance du brevet:
**05.06.2002 Bulletin 2002/23**

(51) Int Cl.⁷: **G01D 5/26**, H01L 31/02

(21) Numéro de dépôt: **98400519.9**

(22) Date de dépôt: **04.03.1998**

(54) **Dispositif de mesure de position et de déplacement sans contact**

Vorrichtung für kontaktlose Positions- und Verschiebungsmessung

Device for non-contact measuring of positon and displacement

(84) Etats contractants désignés:
**AT BE CH DE DK ES FI FR GB GR IE IT LI LU MC
NL PT SE**

(30) Priorité: **09.05.1997 FR 9705722**

(43) Date de publication de la demande:
**11.11.1998 Bulletin 1998/46**

(73) Titulaire: **Vishay S.A.
06003 Nice Cedex (FR)**

(72) Inventeur: **Flassayer, Claude
06640 Saint Jeannet (FR)**

(74) Mandataire: **Keib, Gérard et al
NOVAMARK TECHNOLOGIES
Anciennement Brevets Rodhain & Porte
122, Rue Edouard Vaillant
92593 Levallois Perret Cedex (FR)**

(56) Documents cités:
**US-A- 5 541 652**

• **PATENT ABSTRACTS OF JAPAN vol. 8, no. 139
(E-253) [1576] , 28 juin 1984 & JP 59 050579 A
(KOMATSU SEISAKUSHO K.K.), 23 mars 1984**
• **PATENT ABSTRACTS OF JAPAN vol. 12, no. 396
(P-774), 21 octobre 1988 & JP 63 137319 A
(KYOCERA CORP), 9 juin 1988**
• **PATENT ABSTRACTS OF JAPAN vol. 11, no. 122
(E-500) [2569] , 16 avril 1987 & JP 61 269384 A
(NISSAN MOTOR CO LTD), 28 novembre 1986**
• **PATENT ABSTRACTS OF JAPAN vol. 15, no. 179
(E-1064), 8 mai 1991 & JP 03 042879 A
(YAMATAKE HONEYWELL CO LTD), 25 février
1991**

Printed by Jouve, 75001 PARIS (FR)

**Description**

La présente invention concerne un dispositif de mesure de position et de déplacement sans contact comportant au moins une source lumineuse et au moins un capteur photosensible, susceptibles de se déplacer l'un par rapport à l'autre, ledit capteur photosensible génère, lorsqu'il est éclairé par un faisceau lumineux émis par la source lumineuse, au moins un signal électrique représentatif de la position relative de cette source par rapport au capteur photosensible.

On connaît des dispositifs de mesure de position et de déplacement dans lesquels la position d'un objet mobile est repérée par un curseur qui se déplace sur une piste résistive ou piste potentiométrique Un premier inconvénient de ce type de capteurs résulte de leur manque de précision à cause de l'usure provoquée par les frottements du curseur sur la piste résistive ou potentiométrique qui réduit la durée de vie du capteur. Ceci rend ces dispositifs inadaptés à des applications dans lesquelles la position de l'objet mobile doit être définie avec une grande précision. En outre, la durée de vie de tels dispositifs est d'autant plus limitée qu'ils fonctionnent dans des environnements sévères où existent notamment des hautes températures et des niveaux de vibrations élevés.

On connaît également des dispositifs comportant des capteurs de position sans contact, dits à effet latéral continu. Ces capteurs sont généralement constitués par une cellule photosensible comportant une jonction PIN qui génère, lorsqu'elle est éclairée par un spot lumineux, une charge électrique proportionnelle à l'intensité lumineuse dudit spot. La charge électrique générée se déplace à travers la zone P de la jonction PIN. Dans la mesure où ladite zone P présente une résistivité uniforme, le photocourant collecté par une électrode d'extrémité est inversement proportionnel à la distance entre la position du spot lumineux et l'électrode considérée.

Dans les documents Patent abstract of Japan JP 59 050579, US-A-5 541 652 et Patent abstract of Japan JP 63 137319, on a également proposé de recouvrir les deux faces de la jonction PIN de couches conductrices et/ou résistives, la position du spot lumineux étant déterminée par la mesure des courants circulant dans les couches conductrices.

Un inconvénient de ce type de capteurs résulte du fait que les cellules photosensibles ne sont pas parfaitement linéaires en raison notamment des inhomogénéités de la résistance de surface de la zone P de la jonction PIN. En outre, la charge électrique qui se déplace à travers cette zone P dépend de la température et de l'intensité lumineuse ainsi que des caractéristiques physiques de la jonction PIN.

Le but de l'invention est de réaliser un dispositif de mesure de position et de déplacement sans contact qui soit apte à délivrer des signaux électriques indépendants de la température, des variations de l'intensité lumineuse délivrée par la source et des caractéristiques physiques de la cellule photosensible utilisée pour générer lesdits signaux électriques.

Un autre but de l'invention est de réaliser un dispositif de mesure de position et de déplacement sans contact muni d'un capteur photosensible dont les dimensions et la forme peuvent être aisément adaptées pour détecter et mesurer les déplacements d'un objet aussi bien sur une trajectoire linéaire que sur des trajectoires curvilignes.

Ces buts sont atteints au moyen d'un dispositif de mesure de position dans lequel le capteur photosensible comporte une pluralité de couches déposées sur un support, soit au moins ne première couche résistive, au moins une deuxième couche photosensible destinée à délivrer des charges électriques lorsqu'elle est éclairée par le faisceau lumineux émis par la source et au moins une troisième couche métallique destinée à collecter lesdites charges électriques générées par la deuxième couche photosensible.

Selon l'invention, ce dispositif est caractérisé en ce que la première couche résistive est destinée à former une couche potentiométrique, délivrant à ses extrémités des tensions électriques dont les valeurs dépendent de la position et du déplacement relatifs de la source lumineuse par rapport à la couche photosensible.

Un avantage important de cette structure par rapport aux dispositifs de l'art antérieur provient du fait que les signaux électriques délivrés par le capteur photosensible selon l'invention sont pratiquement indépendants des caractéristiques physiques de la couche photosensible. En outre, la piste potentiométrique constituée par la première couche résistive peut être fabriquée indépendamment de la deuxième couche photosensible. Ceci permet d'en optimiser les caractéristiques électriques et physiques de manière à adapter le dispositif de mesure à différentes applications.

Selon une caractéristique importante de l'invention, la première couche résistive est totalement ou partiellement transparente et présente une résistivité élevée.

Selon une autre caractéristique de l'invention, le support sur lequel sont déposées la première couche résistive, la deuxième couche photosensible et la troisième couche métallique peut être constitué par un matériau souple.

Ainsi, le dispositif de mesure selon l'invention peut être utilisé pour déterminer la position et le déplacement relatifs de la source lumineuse par rapport au capteur photosensible sur des trajectoires curvilignes.

D'autres caractéristiques et avantages de l'invention ressortiront de la description qui va suivre, prise à titre d'exemple non limitatif; en référence aux figures annexées dans lesquelles:

-   La figure 1 représente schématiquement, en perspective, un dispositif de mesure de position et de déplacement relatifs selon l'invention.

- La figure 2 représente partiellement une vue de face d'un capteur photosensible équipant le dispositif de la figure 1 selon un premier mode de réalisation de l'invention;

- la figure 3 représente partiellement une vue de face d'un capteur photosensible équipant le dispositif de la figure 1 selon un deuxième mode de réalisation de l'invention;

- la figure 4 représente schématiquement une vue en perspective d'un capteur photosensible selon le premier mode de réalisation de l'invention;

- la figure 5 représente un schéma électrique équivalent du capteur photosensible de la figure 2;

- la figure 6 représente un schéma électrique équivalent du capteur photosensible de la figure 3;

- la figure 7 représente schématiquement une vue de dessus d'un ensemble d'éléments photosensibles rectilignes déposés sur un substrat;

- la figure 8 représente schématiquement une piste résistive circulaire destinée à équiper un capteur photosensible rotatif selon l'invention.

- la figure 9 représente schématiquement un dispositif de mesure de position et de déplacement selon l'invention équipé d'un capteur photosensible rotatif muni d'un support souple transparent.

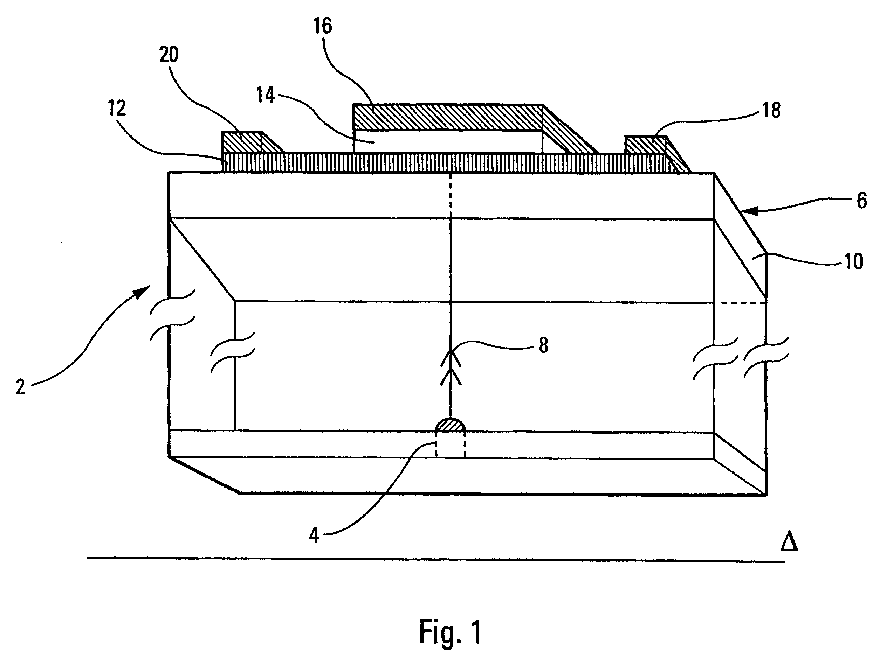

La figure 1 représente schématiquement un dispositif de mesure de position et de déplacement sans contact 2 comportant au moins une source lumineuse 4 et au moins un capteur photosensible 6. La source lumineuse 4 et le capteur photosensible 6 sont susceptibles de se déplacer l'un par rapport à l'autre selon la direction indiquée par l'axe $\Delta$. ledit capteur photosensible 6 génère, lorsqu'il est éclairé par faisceau lumineux 8 émis par la source lumineuse 4, au moins un signal électrique représentatif de la position relative de la source lumineuse 4 par rapport au capteur photosensible 6.

Le dispositif de mesure de position et de déplacement illustré par la figure 1 est muni d'un capteur photosensible linéaire comportant une pluralité de couches déposées sur un support 10, soit au moins une première couche résistive 12 destinée à former une piste potentiométrique, au moins une deuxième couche photosensible 14 destinée à délivrer des charges électriques lorsqu'elle est éclairée par le faisceau lumineux 8 émis par la source 4 et au moins une troisième couche métallique 16 destinée à collecter lesdites charges électriques générées par la deuxième couche photosensible 14

Préférentiellement, la première couche résistive 12 présente une résistivité élevée et la deuxième couche photosensible 14 comporte une jonction PIN constituant une photodiode. Cette deuxième couche photosensible 14 est réalisée en Silicium amorphe et comporte une première sous-couche 14a dopée négativement, une deuxième sous-couche 14b intrinsèque (neutre) et une troisième sous-couche 14c dopée positivement. Ladite première couche résistive 12 peut être totalement ou partiellement transparente, et comporte une première borne de connexion électrique 18 et une deuxième borne de connexion électrique 20 destinées respectivement à prélever un premier signal électrique $V_1$ et un deuxième signal électrique $V_2$ entre ladite première couche résistive 12 et la troisième couche métallique 16.

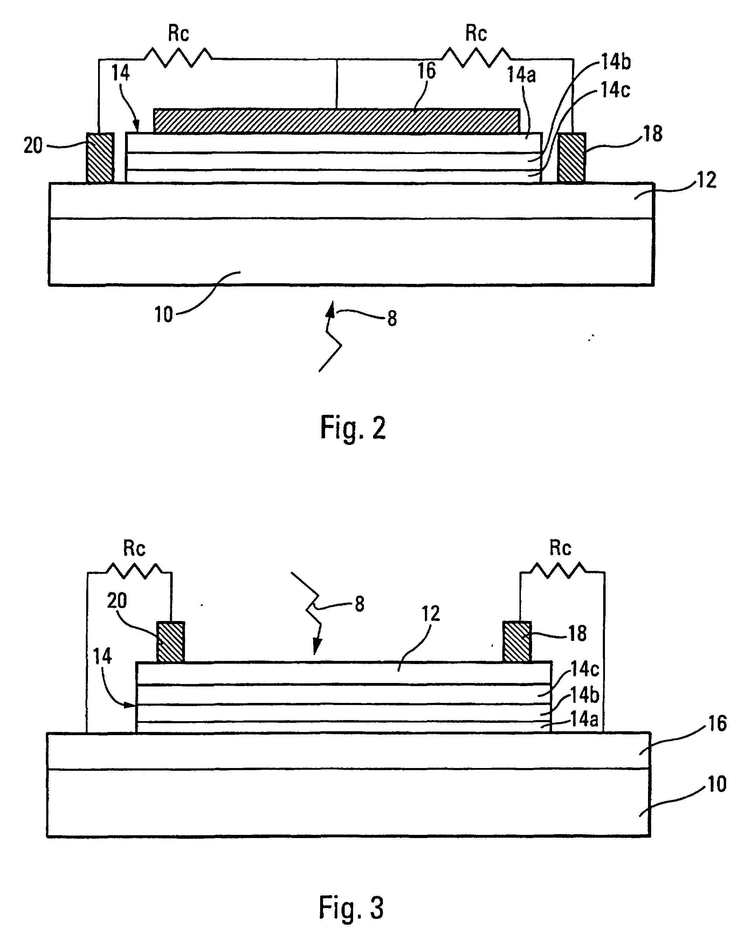

La figure 2 illustre un premier mode de réalisation de l'invention dans lequel, le support 10 est transparent et la couche résistive 12 est agencée entre ce support transparent 10 et la couche photosensible 14, tandis que la couche métallique 16 est déposée sur la couche photosensible 14.

La figure 3 illustre un deuxième mode de réalisation de l'invention dans lequel, le support 10 est constitué par un matériau opaque et souple et la couche métallique 16 est agencée entre ce support transparent 10 et la couche photosensible 14 tandis que la couche résistive 12 est déposée sur la couche photosensible 14.

Comme on peut le voir sur les figures 2 et 3, le dispositif de mesure de position et de déplacement selon l'invention comporte une première résistance électrique de charge $R_c$ reliée, d'une part, à la première borne de connexion électrique 18, et d'autre part, à la couche métallique 16, et une deuxième résistance électrique de charge $R_c$ reliée, d'une part, à la deuxième borne de connexion électrique 20, et d'autre part, à ladite couche métallique 16.

Avec les structures illustrées par les figures 2 et 3, la partie éclairée de la jonction PIN constitue un curseur optique qui relie électriquement la couche métallique 16 à un point bien précis de la piste potentiométrique coïncidant avec le point d'impact du faisceau lumineux sur la piste résistive 12. De ce fait, d'une part, il n'y a de contact mécanique mobile entre le curseur et la piste potentiométrique, et d'autre part, il n'y a pas de contact électrique, ni de contact mécanique entre la source lumineuse et le capteur photosensible.

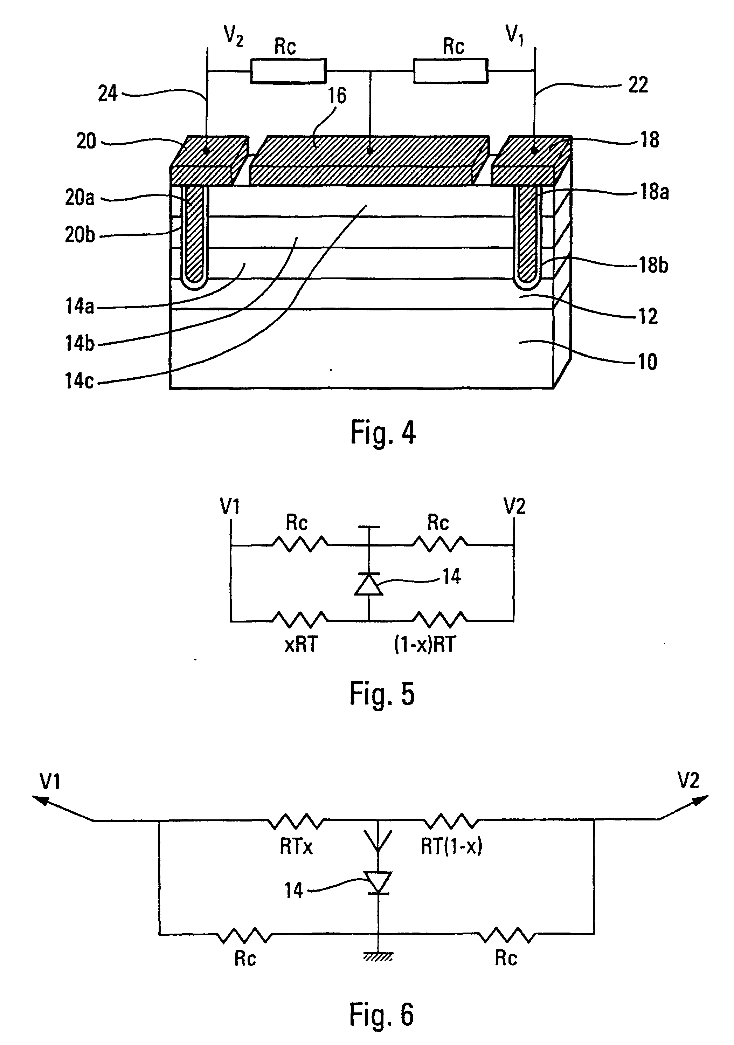

Comme on peut le voir sur la figure 4, les deux bornes de connexion électrique 18 et 20 se prolongent respectivement par un doigt conducteur 18a et par un doigt conducteur 20a, isolés électriquement de la jonction PIN respectivement par une première zone isolante 18b et une deuxième zone isolante 20b. Les doigts conducteurs 18a et 20a permettent de connecter la couche résistive transparente 12 respectivement à un premier fil de contact extérieur 22 et à un deuxième fil de contact extérieur 24. Les premier et deuxième fils de contact 22 et 24 sont respectivement reliés aux résistances extérieures de charge Rc aux bornes desquelles sont prélevés les signaux électriques $V_1$ et $V_2$ générés par la photodiode 14.

Les doigts conducteurs 18a et 20a ainsi que les zones isolantes 18b et 20b peuvent être réalisés par découpage laser et dépôt sous vide.

Préférentiellement, la couche résistive 12 est réalisée en oxyde d'Etain $SnO_2$ ou en Indium dopé à l'Etain ITO (Indium Tin Oxyd, en langue anglaise). Cependant tout matériau transparent, homogène et présentant une résistivité élevée peut constituer la piste potentiométrique 12 sans sortir du cadre de l'invention.

Les figures 5 et 6, représentent respectivement un schéma électrique équivalent au capteur photosensible 6 selon le premier mode de réalisation de l'invention, et un schéma électrique équivalent au capteur photosensible 6 selon le deuxième mode de réalisation de l'invention. Dans les deux cas, la piste potentiométrique 12 est représentée par sa résistance linéaire totale $R_t$ et la photodiode 14 est équivalente à un générateur de tension de force électromotrice E alimentant les deux résistances extérieures $R_c$. En représentant par x la position du point d'impact, sur la couche transparente 12, du faisceau émis par la source lumineuse 6, la piste potentiométrique 12 est divisée en deux zones situées de part et d'autres de ce point d'impact, soit une première zone ayant une résistance électrique $xR_t$ et une deuxième zone ayant une résistance électrique $(1-x)R_t$.

En fonctionnement, les tensions électriques $V_1$ et $V_2$ délivrées par la photodiode 14, respectivement à la borne 18 et à la borne 20, dépendent de la position x d'impact du spot sur la couche transparente 12 et sont données par les expressions suivantes:

$$V1 = E \frac{Rc}{xRt + Rc}$$

$$V2 = E \frac{Rc}{(1 - x)Rt + Rc}$$

Le rapport de ces tensions électriques s'exprime par la relation:

$$\frac{V1}{V2} = \frac{Rc + xRt}{Rc + (1 - x)Rt}$$

Ce rapport dépend des valeurs des résistances extérieures Rc, de la valeur de la résistance $R_t$ de la piste potentiométrique et de la position relative x de la source lumineuse 4 par rapport capteur photosensible 6.
En choisissant une valeur de résistance de charge $R_c$ égale à une fraction entière de la valeur de la résistance $R_t$, le rapport $\frac{V1}{V2}$ ne dépend plus que de la position x. En effet, si $Rc = \frac{Rt}{k}$ où k est nombre entier par exemple, alors

$$\frac{V1}{V2} = \frac{1 + xk}{1 + (1 - x)k}$$

Si k=2, alors

$$\frac{V1}{V2} = \frac{1 + 2x}{3 - 2x}$$

On constate alors que le rapport des tensions V1 et V2 ne dépend que de la position x. Un choix judicieux de la résistivité de la couche potentiométrique 12 et/ou des résistances de charge Rc permet de linéariser ce rapport.

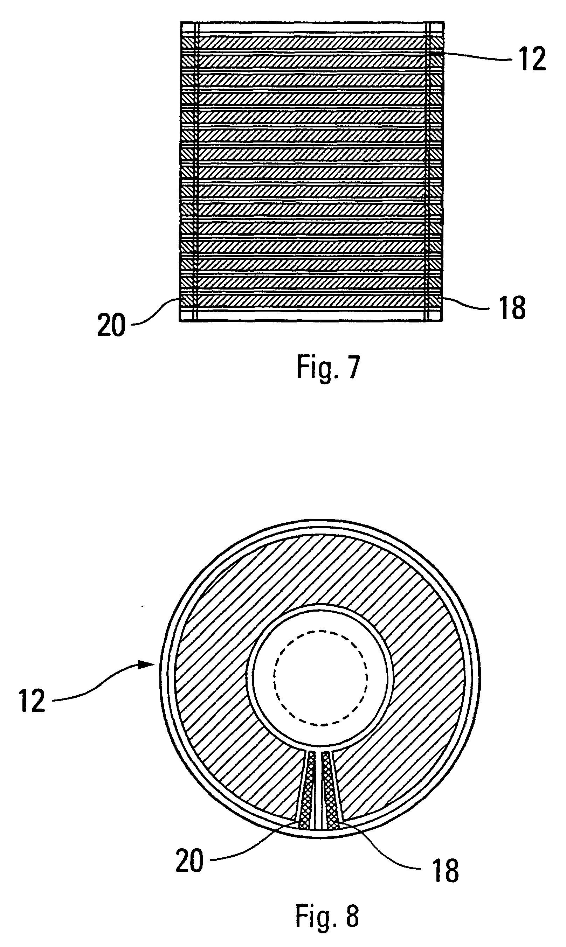

La figure 7 représente schématiquement une vue de dessus d'un ensemble d'éléments photosensibles rectilignes déposés sur un substrat et destiné à équiper un dispositif de mesure de position et de déplacement linéaire.

La figure 8 représente un exemple de réalisation d'une couche résistive 12 destinée à équiper un dispositif de mesure de position et de déplacement rotatif.

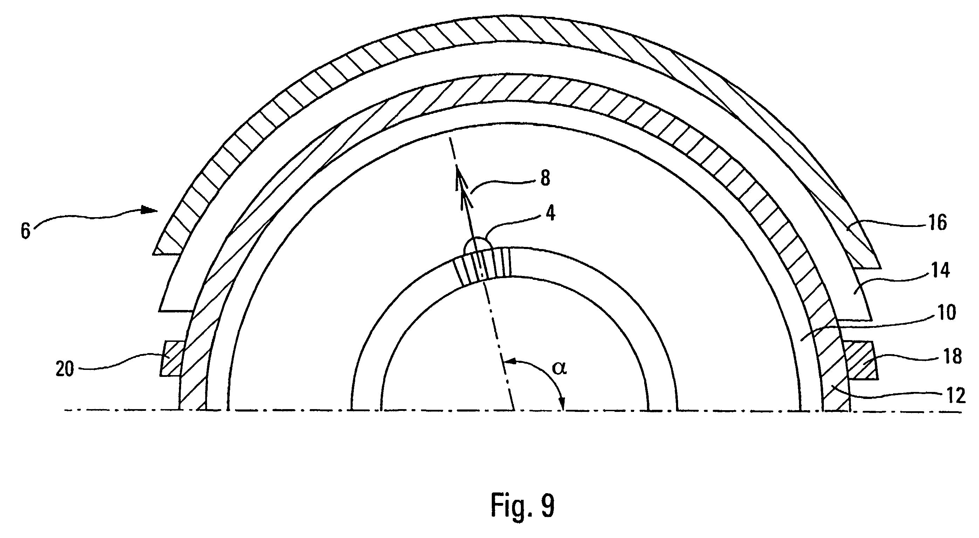

La figure 9 illustre schématiquement un mode de réalisation d'un tel dispositif dans lequel le support transparent 10 est constitué par un matériau souple. Ce mode de réalisation est adapté aux applications dans lesquelles la source lumineuse 4 se déplace sur une trajectoire curviligne. Dans ce cas, le signal délivré par le capteur photosensible 6 représente une image de la position angulaire relative $\alpha$ de la source de lumière 4 par rapport au capteur photosensible 6.

L'ensemble des couches superposées constituant le dispositif selon l'invention peut présenter d'autres formes et des longueurs différentes adaptées à des utilisations spécifiques sans sortir du cadre de l'invention.

Ceci est rendu possible par l'utilisation de supports souples. En outre, ladite couche résistive 12 peut être fabriquée aisément en grande quantité avec des caractéristiques électriques et géométriques variées offrant ainsi une grande souplesse d'adaptation du dispositif selon l'invention à des utilisations variées.

La source lumineuse 4 peut être fixée sur n'importe quel objet dont on mesure la position et le déplacement relatifs par rapport au capteur photosensible 6. L'invention s'applique également à des applications dans lesquelles la source lumineuse 4 est immobile et le capteur photosensible 6 est mobile par rapport à ladite source lumineuse 4.

## Revendications

1. Dispositif de mesure de position et de déplacement sans contact (2) comportant au moins une source lumineuse (4) et au moins un capteur photosensible (6), susceptibles de se déplacer l'un par rapport à l'autre, ledit capteur photosensible (6) étant éclairé par un faisceau lumineux (8) émis par la source lumineuse (4), et comportant une pluralité de couches déposées sur un support (10), soit au moins une première couche résistive (12), au moins une deuxième couche photosensible (14) destinée à délivrer des charges électriques lorsqu'elle est éclairée par le faisceau lumineux émis par la source (4) et au moins une troisième couche métallique (16) destinée à collecter lesdites charges électriques générées par la deuxième couche photosensible (14)
**caractérisé en ce que** la première couche résistive (12) est destinée à former une couche potentiométrique, délivrant à ses extrémités des tensions électriques dont les valeurs dépendent de la position et du déplacement relatifs de la source lumineuse par rapport à la couche photosensible.

2. Dispositif selon la revendication 1, **caractérisée en ce que** la première couche résistive (12) est transparente et présente une résistivité élevée.

3. Dispositif selon la revendication 1, **caractérisée en ce que** la deuxième couche photosensible (14) comporte une jonction PIN déposée entre la première couche résistive (12) et la troisième couche métallique (16) de manière à constituer une photodiode.

4. Dispositif selon l'une des revendications 1 à 3, **caractérisé en ce que** la première couche résistive (12) comporte une première borne de connexion électrique (18) et une deuxième borne de connexion électrique (20) destinées respectivement à prélever un premier signal électrique V1 et un deuxième signal électrique V2 entre ladite première couche résistive (12) et la troisième couche métallique (16).

5. Dispositif selon l'une des revendications 1 à 4, **caractérisé en ce qu'**il comporte une première résistance électrique Rc reliée, d'une part, à la première borne de connexion électrique (18), et d'autre part, à la troisième couche métallique (16), et une deuxième résistance électrique Rc reliée, d'une part, à la deuxième borne de connexion électrique, et d'autre part, à la troisième couche métallique (16).

6. Dispositif selon l'une des revendications 1 à 5, **caractérisé en ce que** le support (10) est constitué par un matériau transparent et la couche résistive (12) est agencée entre ce support transparent (10) et la couche photosensible (14) tandis que la couche métallique (16) est déposée sur la couche photosensible (14).

7. Dispositif selon l'une des revendications 1 à 5, **caractérisé en ce que** le support (10) est constitué par un matériau opaque et la couche métallique (16) est agencée entre ce support opaque (10) et la couche photosensible (14) tandis que la couche résistive (12) est déposée sur la couche photosensible (14).

8. Dispositif selon la revendication 7, **caractérisée en ce que** le support (10) est constitué par un matériau souple.

9. Dispositif selon l'une des revendications 1 à 8, **caractérisé en ce que** la couche résistive transparente (12) est en oxyde d'Etain $SnO_2$.

10. Dispositif selon l'une des revendications 1 à 9, **caractérisé en ce que** la deuxième couche photosensible (14) est en Silicium amorphe.


**Patentansprüche**

1. Vorrichtung für kontaktlose Positions- und Verschiebungsmessung (2) mit mindestens einer Lichtquelle (4) und mindestens einem lichtempfindlichen Sensor (6), die gegeneinander verschoben werden können, wobei der lichtempfindliche Sensor (6) durch einen von der Lichtquelle (4) ausgehenden Lichtstrahl (8) beleuchtet wird, und mit einer Vielzahl von auf einem Träger (10) aufgebrachten Schichten, nämlich mindestens einer ersten, resistiven Schicht (12), mindestens einer zweiten, lichtempfindlichen Schicht (14) zum Liefern elektrischer Ladungen, wenn sie durch den von der Quelle (4) ausgehenden Lichtstrahl beleuchtet wird, und mindestens einer dritten, metallischen Schicht (16) zum Erfassen der durch die zweite, lichtempfindliche Schicht (14) erzeugten elektrischen Ladungen, **dadurch gekennzeichnet, dass** die erste resistive Schicht (12) zur Bildung einer potentiometrischen Schicht bestimmt ist, die an ihren Enden elektrische Spannungen liefert, deren Werte von der relativen Position und der relativen Verschiebung der Lichtquelle in Bezug auf die lichtempfindliche Schicht abhängen.

2. Vorrichtung nach Anspruch 1, **dadurch gekennzeichnet, dass** die erste, resistive Schicht (12) durchsichtig ist und einen erhöhten spezifischen Widerstand aufweist.

3. Vorrichtung nach Anspruch 1, **dadurch gekennzeichnet, dass** die zweite, lichtempfindliche Schicht (14) einen PIN-Übergang aufweist, der zwischen der ersten, resistiven Schicht (12) und der dritten, metallischen Schicht (16) so aufgebracht ist, dass er eine Photodiode bildet.

4. Vorrichtung nach einem der Ansprüche 1 bis 3, **dadurch gekennzeichnet, dass** die erste, resistive Schicht (12) einen ersten elektrischen Anschluss (18) und einen zweiten elektrischen Anschluss (20) aufweist, die jeweils dazu bestimmt sind, ein erstes elektrisches Signal V1 und ein zweites elektrisches Signal V2 zwischen der ersten, resistiven Schicht (12) und der dritten, metallischen Schicht (16) abzugreifen.

**5.** Vorrichtung nach einem der Ansprüche 1 bis 4, **dadurch gekennzeichnet, dass** sie einen ersten elektrischen Widerstand Rc, der einerseits mit dem ersten elektrischen Anschluss (18) und andererseits mit der dritten, metallischen Schicht (16) verbunden ist, sowie einen zweiten elektrischen Widerstand Rc aufweist, der einerseits mit dem zweiten elektrischen Anschluss und andererseits mit der dritten, metallischen Schicht (16) verbunden ist.

**6.** Vorrichtung nach einem der Ansprüche 1 bis 5, **dadurch gekennzeichnet, dass** der Träger (10) aus einem durchsichtigen Material besteht und die Widerstandsschicht (12) zwischen dem durchsichtigen Träger (10) und der lichtempfindlichen Schicht (14) ausgebildet ist, während die metallische Schicht (16) auf der lichtempfindlichen Schicht (14) aufgebracht ist.

**7.** Vorrichtung nach einem der Ansprüche 1 bis 5, **dadurch gekennzeichnet, dass** der Träger (10) aus einem undurchsichtigen Material besteht und die metallische Schicht (16) zwischen dem undurchsichtigen Träger (10) und der lichtempfindlichen Schicht (14) aufgebracht ist, während die resistive Schicht (12) auf der lichtempfindlichen Schicht (14) aufgebracht ist.

**8.** Vorrichtung nach Anspruch 7, **dadurch gekennzeichnet, dass** der Träger (10) aus einem biegsamen Material besteht.

**9.** Vorrichtung nach einem der Ansprüche 1 bis 8, **dadurch gekennzeichnet, dass** die durchsichtige resistive Schicht (12) aus Zinnoxid $SnO_2$ besteht.

**10.** Vorrichtung nach einem der Ansprüche 1 bis 9, **dadurch gekennzeichnet, dass** die zweite, lichtempfindliche Schicht (14) aus amorphem Silizium besteht.

**Claims**

**1.** A device (2) for contactless measurement of position and displacement, comprising at least one light source (4) and at least one photosensitive sensor (6) movable relative to one another, the photosensitive sensor (6) being illuminated by a light beam (8) emitted by the light source (4) and comprising a number of layers disposed on a support (10), i.e. at least a first resistive layer (12), at least a second photosensitive layer (14) adapted to deliver electric charges when illuminated by the light beam emitted by the source (4), and at least a third metal layer (16) adapted to collect the electric charges generated by the second photosensitive layer (14), **characterised in that** the first resistive layer (12) is adapted to form a potentiometric layer which at its ends delivers voltages depending in value on the position and displacement of the light source relative to the photosensitive layer.

**2.** A device according to claim 1, **characterised in that** the first resistive layer (12) is transparent and has high resistivity.

**3.** A device according to claim 1, **characterised in that** the second photosensitive layer (14) comprises a PIN junction disposed between the first resistive layer (12) and the third metal layer (16) so as to form a photodiode.

**4.** A device according to any of claims 1 to 3, **characterised in that** the first resistive layer (12) comprises a first electric connection terminal (18) and a second electric connection terminal (20) respectively adapted to sample a first electric signal (V1) and a second electric signal (V2) between the first resistive layer (12) and the third metal layer (16).

**5.** A device according to any of claims 1 to 4, **characterised in that** it comprises a first electric resistor (Rc) connected on the one hand to the first electric connection terminal (18) and on the other hand to the third metal layer (16), and a second electric resistor (Rc) connected on the one hand to the second electric connection terminal and on the other hand to the third metal layer (16).

**6.** A device according to any of claims 1 to 5, **characterised in that** the support (10) is of transparent material and the resistive layer (12) is disposed between the transparent support (10) and the photosensitive layer (14) whereas the metal layer (16) is disposed on the photosensitive layer (14).

**7.** A device according to any of claims 1 to 5, **characterised in that** the support (10) is of opaque material and the metal layer (16) is disposed between the opaque support (10) and the photosensitive layer (14) whereas the resistive layer (12) is disposed on the photosensitive layer (14).

**8.** A device according to claim 7, **characterised in that** the support (10) is made of flexible material.

**9.** A device according to any of claims 1 to 8, **characterised in that** the transparent resistive layer (12) is of tin oxide ($SnO_2$).

**10.** A device according to any of claims 1 to 9, **characterised in that** the second photosensitive layer (14) is of amorphous silica.

Fig. 1

EP 0 877 231 B1

Fig. 2

Fig. 3

Fig. 4

Fig. 5

Fig. 6

Fig. 7

Fig. 8

Fig. 9

EP 0 877 231 B1